**Europäisches Patentamt**

**European Patent Office**

**Office européen des brevets**

(19)

(11) Veröffentlichungsnummer: **0 006 167**
**B1**

(12) # EUROPÄISCHE PATENTSCHRIFT

(45) Veröffentlichungstag der Patentschrift:
02.06.82

(51) Int. Cl.³: **G 11 C 17/00, G 11 C 11/40**

(21) Anmeldenummer: **79101716.3**

(22) Anmeldetag: **01.06.79**

(54) **Mehrwertiger FET-Festwertspeicher.**

(30) Priorität: **13.06.78 US 915338**

(43) Veröffentlichungstag der Anmeldung:
**09.01.80 Patentblatt 80/1**

(45) Bekanntmachung des Hinweises auf die Patenterteilung:
**02.06.82 Patentblatt 82/22**

(84) Benannte Vertragsstaaten:
**DE FR GB**

(56) Entgegenhaltungen:
**DE-A-2 638 703**
**DE-A-2 731 873**
**US-A-4 130 891**

(73) Patentinhaber: **International Business Machines Corporation, Armonk, N.Y. 10504 (US)**

(72) Erfinder: **Beilstein Jr., Kenneth E., 11 Walden Woods, Essex Junction Vermont 05452 (US)**
Erfinder: **Kotecha, Harish N., 31 Margaret Street, Essex Junction, Vt.05452 Chittenden (US)**

(74) Vertreter: **Rudolph, Wolfgang, Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Mehrwertiger FET-Festwertspeicher

Die Anmeldung betrifft einen Festwertspeicher nach dem Oberbegriff des Anspruchs 1.

Die FET-Speichertechnik befaßte sich bisher mit der Speicherung zweiwertiger elektrischer Signale, wie sie beispielsweise beschrieben ist in der US-Patentschrift 3 728 696. In einem herkömmlichen zweiwertigen FET-Festwertspeicher bilden mehrere Adreßeingangsleitungen und Wahlleitungen eine Matrix mit Bereichen eines Halbleitersubstrates. Zweiwertige Information wird an Stellen zwischen benachbarten Halbleiterbereichen durch Vorhandensein oder Fehlen von Feldeffekttransistoren an der betreffenden Stelle gespeichert. Abwechselnde Halbleiterbereiche werden selektiv mit einer Bezugsspannung verbunden und die übrigen dazwischenliegenden Bereiche selektiv mit einem gemeinsamen Ausgangspunkt durch Selektions-Feldeffekttransistoren in Reihenschaltung mit jedem Bereich verbunden. Selektionssignale werden an die Selektionstransistoren eines benachbarten Bereichspaares angelegt und verbinden einen Bereich mit der Bezugsspannung und den anderen mit dem Ausgang. Auf diese Weise wird ein zweiwertiges Ausgangssignal geliefert, das eine Funktion der an einer bestimmten adressierten Speicherstelle gespeicherten Daten ist.

Die Entwicklungsrichtung für die Halbleiterspeichertechnik zielt auf eine Erhöhung der Speicherelemente pro Flächeneinheit auf dem Halbleiterchip. Dadurch wird die Speicherkapazität bezogen auf die Herstellungskosten des Halbleiterspeichers erhöht.

Im Laufe der Entwicklung der Halbleiterindustrie hat sich die Technik der Ionenimplantation in den Kanalbereich eines FET so weit entwikkelt, daß die Schwellwertspannung für den FET so eingestellt werden kann, daß die Gatespannung, bei der der FET einschaltet, entsprechend der vorliegenden Anwendung angepaßt werden kann. Zugehörige Techniken sind beschrieben in der US-Patentschrift 3 873 372. Bei einem N-Kanal FET, wo die N-leitende Quelle und Senke in einem Substrat mit P-Leitfähigkeit ausgebildet sind, kann die Schwellwertspannung des FET durch zusätzliche Ionenimplantation P-leitender Dotierungsmittel in den Kanalbereich erhöht werden. Andererseits kann die Schwellwertspannung des FET durch Ionenimplantation N-leitender Dotierungsmittel in den Kanalbereich heruntergesetzt werden. Das Ausmaß der Änderung der Schwellwertspannung während der Ionenimplantation ist ungefähr proportional der Dosierung des Dotierungsmittels im Kanalbereich. Diese Schwellwertspannung kann dadurch geregelt werden, daß man entweder den Strom oder die Belichtungszeit für den Ionenstrahl der Implantation oder auch andere Prozeßfaktoren steuert.

In der bisherigen Technik wurden für die Unterstützungsschaltung eines zweiwertigen FET-Festwertspeichers (ROM) FET-Basisinverterschaltungen verwendet, wie sie beispielsweise beschrieben sind in der US-Patentschrift 3 406 298. Andere herkömmliche Inverterschaltungen zur Verwendung in den Unterstützungsschaltungen für die herkömmlichen zweiwertigen Festwertspeicher werden beschrieben in der US-Patentschrift 4 072 868.

Außerdem ist aus der DE-A-2 731 873 ein Festwertspeicher mit matrixförmig angeordneten Feldeffekttransistoren bekannt, deren Gateelektroden spaltenweise über Wortleitungen ansteuerbar sind, deren Schwellwertspannung ferner entsprechend der zu speichernden Information durch Ionenimplantation im Kanalbereich festlegbar ist, und deren Ausgänge zeilenweise zu Ausgangsbitleitungen verbunden sind.

Die Aufgabe der vorliegenden Erfindung besteht in der Erhöhung der Speicherkapazität pro Flächeneinheit eines Halbleiterspeichers ohne entsprechende Erhöhung der Anzahl der Speicherelemente und in der Schaffung eines verbesserten Festwertspeichers.

Die Aufgabe der Erfindung wird gelöst gemäß Kennzeichen des Anspruchs 1.

Weiterbildungen der Lösung sind in den Kennzeichen der Ansprüche 2 und 3 enthalten.

Bei einem vierwertigen FET-Festwertspeicher wird jedes FET-Speicherelement in seiner Gruppe mit einer Schwellwertspannung gebildet, die einen von vier Werten haben kann.

Die Schwellwertspannung für die FET's in der Gruppe wird zur Zeit der Herstellung durch Ionenimplantation festgelegt. Jeder FET in der Gruppe ist mit seiner Senke an ein Senkenpotential $V_{DD}$ angeschlossen. Ein zweiwertiges Eingangsadreßsignal von einem herkömmlichen zweiwertigen oder binären Generator gestattet dann die Einschaltung ausgewählter FET-Speicherzellen in der Gruppe, und das Ausgangspotential an der Quelle jeder dieser FET-Speicherzellen wird zu $V_{DD}$ minus der jeweiligen Schwellwertspannung der Zelle. Die resultierende Ausgangsspannung ist ein vierwertiges Signal, d. h. sie kann einen von vier Spannungswerten haben. Dieses vierwertige Ausgangssignal kann durch einen vierwertigen Abfrageverstärker, wie er hier beschrieben ist, verstärkt und dann aus einem vierwertigen in ein zweiwertiges Signal umgesetzt werden mittels eines Vierwert-Zweiwert-Konverters, der ebenfalls beschrieben ist. Der resultierende vierwertige FET-Festwertspeicher (FET ROM) kann doppelt so viel Information pro Flächeneinheit speichern wie ein herkömmlicher zweiwertiger Festwertspeicher mit derselben Anzahl von Speicherelementen pro Flächeneinheit des Halbleiterchip. Das Konzept kann auf N Signalwerte der Informationsspeicherung ausgedehnt werden unter Verwendung von FET-Elementen mit N verschiedenen Schwellwertspannungen.

Ein Ausführungsbeispiel der Erfindung ist in den beigefügten Zeichnungen dargestellt und wird anschließend näher beschrieben. Es zeigen:

Fig. 1 in einem Funktionsblockdiagramm des vierwertigen Festwertspeichersystems den Anschluß dieses Systems an den Abfrageverstärker und den Vierwert/Zweiwert-Umsetzer,

Fig. 2 schematisch einen Teil des vierwertigen Festwertspeichers mit der zweiwertigen Eingabe auf den Wortleitungen und der vierwertigen Ausgabe auf den Bitleitungen,

Fig. 3 schematisch einen herkömmlichen Anreicherungs/Verarmungsinverter,

Fig. 4 die Kurve der Ausgangsspannung für den in Fig. 3 gezeigten Inverter,

Fig. 5 schematisch den vierwertigen Abfrageverstärker,

Fig. 6 die Ausgangsspannungskurve für den vierwertigen Abfrageverstärker der Fig. 5,

Fig. 7 schematisch den in Fig. 5 gezeigten Abfrageverstärker mit dem Stromfluß für den Fall, daß die Transistoren T1 und T2 eingeschaltet sind,

Fig. 8 schematisch den in Fig. 5 gezeigten Abfrageverstärker für den Fall, daß alle drei Transistoren T1, T2 und T3 eingeschaltet sind sowie die zugehörige Stromflußverteilung und

Fig. 9a, 9b, 9c, 9d den Vierwert/Zweiwert-Umsetzer.

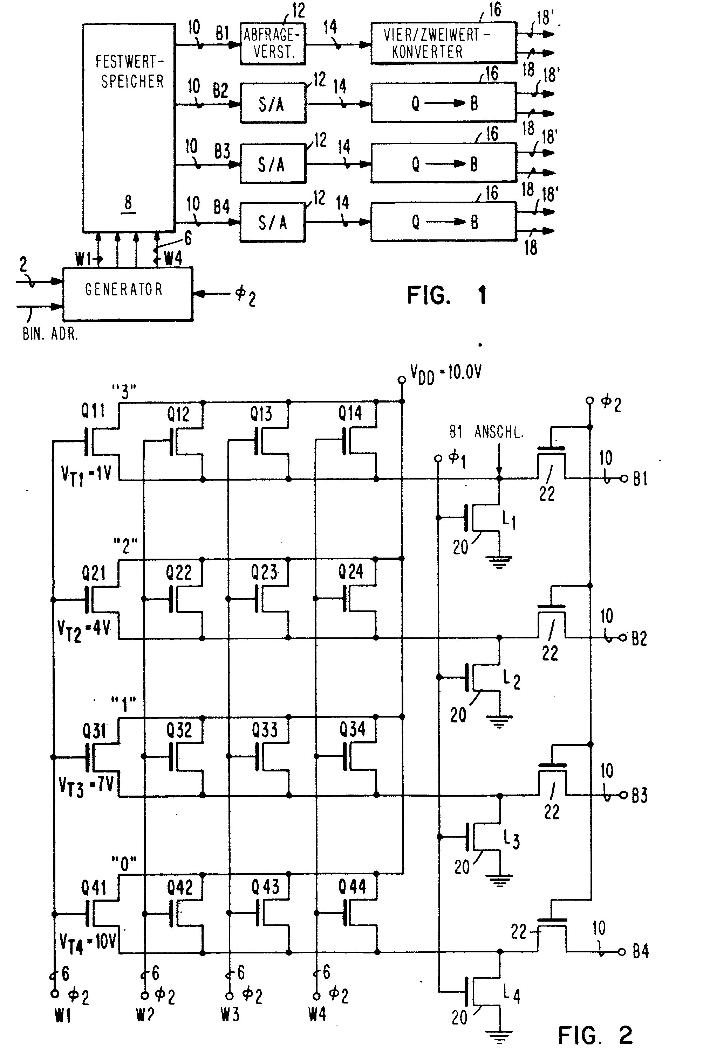

Die Eingabe zu dem in Fig. 1 dargestellten vierwertigen Festwertspeichersystem besteht aus zweiwertigen Adreßsignalen auf der Leitung 2, die an einen herkömmlichen zweiwertigen Generator 4 gehen, dessen zweiwertige Ausgangssignale auf den sogenannten Wortleitungen 6 mit der Bezeichnung W1 bis W4 die Steuerelektroden der FET-Speicherelemente Q11 bis Q44 des in Fig. 2 gezeigten Speichers einschalten.

Fig. 2 zeigt ein schematisches Schaltbild eines Teiles der in Fig. 1 gezeigten Speichergruppe 8 des vierwertigen Festwertspeichers. Die Zeilen von FET-Speicherelementen sind auf dem Speicherchip so angeordnet, daß an ihren Senken das Senkenpotential $V_{DD}$ anliegt und ihre Quellen gemeinsam mit einer Ausgangsbitleitung 10 verbunden sind. Mehrere Zeilen von Speicherelementen sind auf dem Speicherchip so angeordnet, daß die in Spalten nebeneinanderliegenden Speicherelemente mit ihren Gates gemeinsam an eine zweiwertige Eingangswortleitung 6 angeschlossen sind. Zwischen jede Ausgangsbitleitung 10 und Erdpotential ist ein Entladungslastelement 20 so geschaltet, daß die Gates aller Entladungslastelemente 20 gemeinsam ein erstes Taktphasensignal $\Phi 1$ empfangen. An jede Ausgangsbitleitung 10 ist außerdem ein Ausgangsleitelement 22 in Reihe mit dem Entladungslastelement 20 und dem Ausgangsknotenpunkt angeschaltet.

Zur Illustration ist die in Fig. 2 dargestellte Gruppe von Speicherelementen in vier Wörter W1 bis W4 organisiert, von denen jedes vier Bits enthält. Ein Element dieser Speichergruppe ist beschriftet mit der Matrixbezeichnung $Q_{ij}$, wobei i die Nummer der Zeile und j die Nummer der Spalte in der Gruppe ist, wie es in Fig. 2 dargestellt ist.

Während der Herstellung der in Fig. 2 gezeigten Festwertspeichergruppe 8 wird jedes FET-Speicherelement $Q_j$ in der Gruppe selektiv im Kanalbereich mit einer von vier Dosen eines die Leitfähigkeit verstärkenden Dotierungsmittels ionenimplantiert, um so eine von vier vorgegebenen Schwellwertspannungen für das ionenimplantierte Element zu erreichen. Drei Ionenplantationen können ausgeführt werden und der inhärente Schwellwert für einen Kanal ohne Implantation kann als vierte Schwellwertspannung dienen. Die Ionenimplantation kann beide Leitfähigkeiten haben. Wenn z. B. alle FET's in der Gruppe 8 N-Kanalelemente sind, können einige selektiv mit einem P-leitenden Dotierungsmittel implantiert werden, um die Schwellwertspannung für diese Elemente anzuheben, während andere FET's N-leitend dotiert werden können, um die Schwellwertspannung zu reduzieren. Diese selektive Implantation der Elemente in der Speichergruppe 8 der Fig. 2 kann beispielsweise mit drei Ionenimplantations-Sperrmasken ausgeführt werden, die aus herkömmlichem Photoresist zusammengesetzt sind. Die erste Sperrmaske würde beispielsweise die Ionenimplantation in allen Gruppen mit Ausnahme einer ersten Gruppe ausgewählter Speicherelemente verhindern, um so eine erste Schwellwertspannung zu erreichen. Eine zweite Sperrmaske für die Ionenimplantation kann dann die Implantation in allen Gruppen mit Ausnahme einer zweiten Gruppe sperren und so eine zweite Schwellwertspannung erreichen usw., bis vier Gruppen von FET-Elementen mit vier verschiedenen Schwellwertspannungen hergestellt sind. Das Selektionsmuster der Schwellwertspannungen für die FET's in der Speichergruppe 8 der Fig. 2 entspricht der Information, die permanent im Festwertspeicher zu speichern ist. Das Konzept kann auf N Ebenen der Informationsspeicherung mit FET von N verschiedenen Schwellwertspannungen ausgedehnt werden. Die Schwellwertspannung läßt sich außerdem durch Variation der Dicke des Gateoxides einstellen und beispielsweise für die größten gewünschten Schwellwertspannungen dadurch festlegen, daß man die dicke Feldisolatorschicht über dem FET-Kanalbereich bestehen läßt.

Im Betrieb wird an die Gruppe 8 ein erstes Phasentaktsignal $\Phi 1$ angelegt, das die Entladungslastelemente 20 für jede der Ausgangsbitleitungen 10 einschaltet und jegliche Restladung auf den Bitleitungen 10 entlädt. Das Signal $\Phi 1$ schaltet dann die Entladungslastelemente 20 ab und das Taktsignal $\Phi 2$ schaltet die FET-Ausgangsleitelemente 22 in jeder Bitleitung 10 und eine der Wortleitungen 6 des herkömmlichen zweiwertigen Generators 4 entsprechend der Eingabeadresse 2 ein. Die Spannung des Taktimpulses $\Phi 2$, die über die Wortleitung 6 an das Gate eines Speicherelementes angelegt wird, ist mindestens so groß wie die an die Drain dieses Elementes angelegte Spannung $V_{DD}$, so daß auch die Speicherelemente mit der höchsten Schwellwertspannung eingeschaltet werden, wenn sie gewählt werden. Ein Speicherelement $Q_j$ wird eingeschaltet durch Anlegen des Taktsignales $\Phi 2$ an die Wortleitungen $W_j$, wodurch die Spannung auf der angeschlossenen Ausgangsbitleitung 10 ungefähr auf die Höhe der Spannung $V_{DD}$ minus der festgelegten Schwellwertspannung des gewählten FET hochgetrieben wird. Das Ausgangssignal auf der Ausgangsbitleitung 10 nimmt also einen der vier möglichen Werte der Schwellwertspannung an, die dem gewählten FET bei der Herstellung aufgeprägt wurde. Die Speicherkapazität eines Speicherelementes $Q_{ij}$ in der in Fig. 2 gezeigten Gruppe 8 ist also doppelt so groß wie die eines herkömmlichen zweiwertigen FET-Speicherelementes in einem herkömmlichen Festwertspeicher. Beispielsweise können die vierwertigen logischen Pegel 0, 1, 2 und 3 den Signalspannungen von 0 V, 3 V, 6 V bzw. 9 V entsprechen. Das Drainpotential $V_{DD}$ muß 10 V betragen und das Erdpotential 0 V. Die Taktimpulse $\Phi 1$ und $\Phi 2$ haben bei ihrem Übergang einen Ausschlag von 0 bis 10 V. Wenn die äußerste linke Spalte der Speicherelemente Q11, Q21, Q31 und Q41, dargestellt in Fig. 2, durch Ionenimplantation mit Schwellwertspannungen von 1 V, 7 V und 10 V versehen wurden, dann ist bei Anlegen des Taktimpulses $\Phi 2$ an die Wortleitungen W1 das Ausgangssignal auf der entsprechenden Ausgangsbitleitung 10 das Gatepotential $V_{DD}$ minus der aufgeprägten Schwellwertspannung für das jeweilige Speicherelement 9 V für die Bitleitung 1, 6 V für die Bitleitung 2, 3 V für die Bitleitung 3 und 0 V für die Bitleitung 4, was genau den vierwertigen logischen Pegeln 3, 2, 1 bzw. 0 entspricht. Die FET-Elemente $Q_{ij}$ der Gruppe können mit jedem anderen Muster von Schwellwertspannungen ausgelegt werden und auch jede andere Wortleitung $W_j$ kann das Taktimpulssignal $\Phi 2$ führen, so daß man ein ganz anderes Muster von vierwertigen Ausgangssignalen auf den Ausgangsbitleitungen 10 erhält.

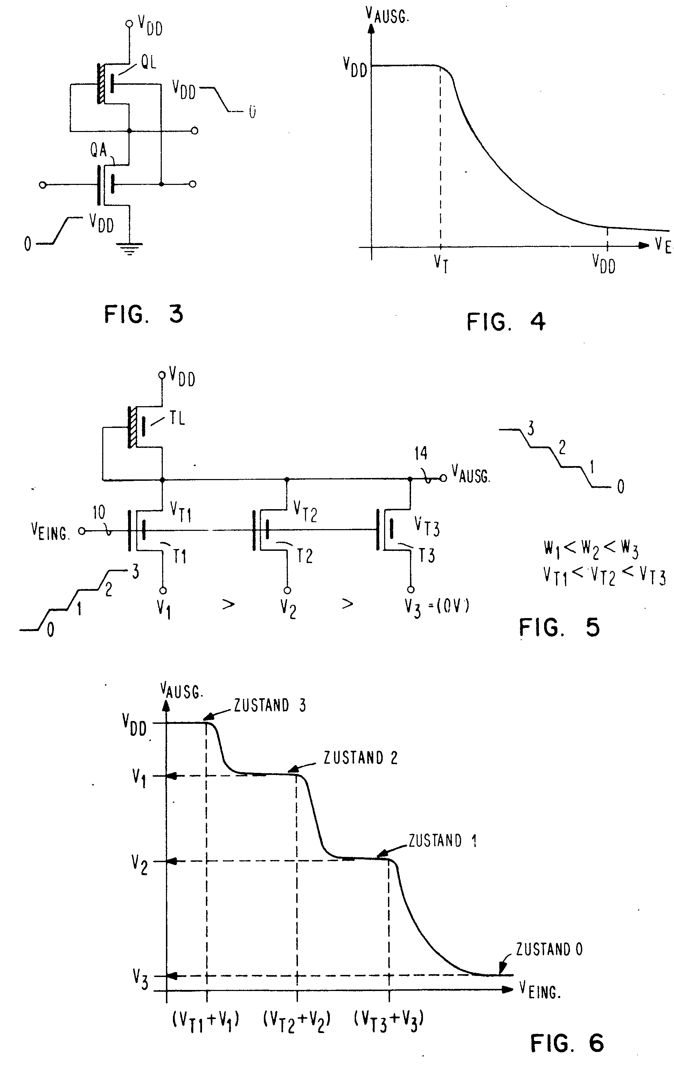

Wie in Fig. 1 dargestellt ist, ist an jeder Ausgangsbitleitung 10 ein vierwertiger Abfrageverstärker 12 angeschlossen, der im einzelnen in Fig. 5 dargestellt ist. Bei der genaueren Beschreibung dieses Abfrageverstärkers wird der in Fig. 3 gezeigte Lastinverter mit N-Kanaldefektelektronen und seine in Fig. 4 gezeigte Ausgangsspannungskurve zugrunde gelegt. Wenn die Eingangsspannung $V_{IN}$ null ist, ist das aktive Element QA abgeschaltet. Da das mit Defektelektronen arbeitende Lastelement QL mit zusammengeschaltetem Gate und Source einen negativen Spannungsausschlag hat, ist die Ausgangsspannung $V_{OUT}$ genauso groß wie das Drainpotential für das Lastelement $V_{DD}$. Bei steigender Spannung $V_{IN}$ wird $V_{OUT}$ auf dem Drainpotential $V_{DD}$ gehalten, bis $V_{IN}$ die Einschaltspannung oder Schwellwertspannung $V_T$ des aktiven Speicherelementes QA überschreitet. Dann schaltet das Speicherelement QA ein und beginnt, Strom durch das Lastelement QL zu leiten, wodurch die Ausgangsspannung $V_{OUT}$ auf fast 0 V oder Erdpotential reduziert wird. Die beiden Zustände sind definiert durch die Ausgangsspannung $V_{OUT} = V_{DD}$, wenn $V_{IN}$ kleiner ist oder genauso groß wie VT und durch $V_{OUT}$ ungefähr gleich 0 V und $V_{IN} = V_{DD}$. Die Schwellwertspannung VT wird in der Praxis mit ungefähr 1 V gewählt, so daß man einen stabilen Pegel erhält, auch wenn Prozeßtoleranzen eine Abweichung des Wertes von etwa 30% verursachen. $V_{OUT}$ wird auf den Wert von $V_{DD}$ gehalten, bis $V_{IN}$ diesen Wert der Schwellwertspannung VT überschreitet. Im anderen Extremfall wird $V_{OUT}$ auf eine Spannung in der Nähe von 0 V geklemmt und ist niedriger als die Schwellwertspannung VT eines aktiven Speicherelementes der nächsten Stufe bei einer kaskadenförmigen Reihe solcher Inverter, auch wenn eine Abweichung von 30% bei VT und von 10% bei der Netzspeisespannung $V_{DD}$ vorliegen.

Die erste Stufe erhält man also, weil das aktive Speicherelement QA für $V_{IN}$ eine bestimmte Spannungsgröße braucht, nämlich die Schwellwertspannung VT, bevor es einschaltet. Der Ausgangsspannungspegel $V_{OUT}$ wird daher effektiv bei $V_{DD}$ so lange festgehalten, wie die Eingangsspannung $V_{IN}$ kleiner ist als die Schwellwertspannung VT. Andererseits liegt das niedrige Festhalten der Spannung $V_{OUT}$ ungefähr bei der Spannung, auf die die Source des aktiven Speicherelementes QA vorgespannt ist.

Diese Beobachtungen können jetzt auf die Analyse der Arbeitsweise des in Fig. 5 dargestellten vierwertigen Abfrageverstärkers angewandt werden.

Fig. 5 zeigt im einzelnen den in Fig. 1 schon gezeigten vierstufigen Abfrageverstärker 12. Die drei aktiven Elemente haben einen gemeinsamen Anschluß für Drain und Gate. Die Schwellwertspannungen für T1, T2 und T3 sind entsprechend $V_{T1}$, $V_{T2}$ und $V_{T3}$. In derselben Reihenfolge ist die Source eines jeden Speicherelementes gelegt auf V1, V2 und V3.

Wenn $V_{IN}$ ansteigt von 0 V wird $V_{OUT} = V_{DD}$, da:

$$(V_{IN} - V_1) < V_{T1} \text{ oder T1 ist aus,}$$
$$(V_{IN} - V_2) < V_{T2} \text{ oder T2 ist aus,}$$
$$(V_{IN} - V_3) < V_{T3} \text{ oder T3 ist aus,}$$

sich ein stabiler Zustand ergibt, z. B. »3«. Wenn $V_{IN}$ ansteigt, so daß:

$$(V_{IN} - V_1) > V_{T1},$$
$$(V_{IN} - V_2) < V_{T2} \text{ und}$$
$$(V_{IN} - V_3) < V_{T3},$$

und das Element T1 einschaltet, fällt $V_{OUT}$ nach Darstellung in Fig. 6 auf einen Wert von etwa V1 von $V_{DD}$ ab.

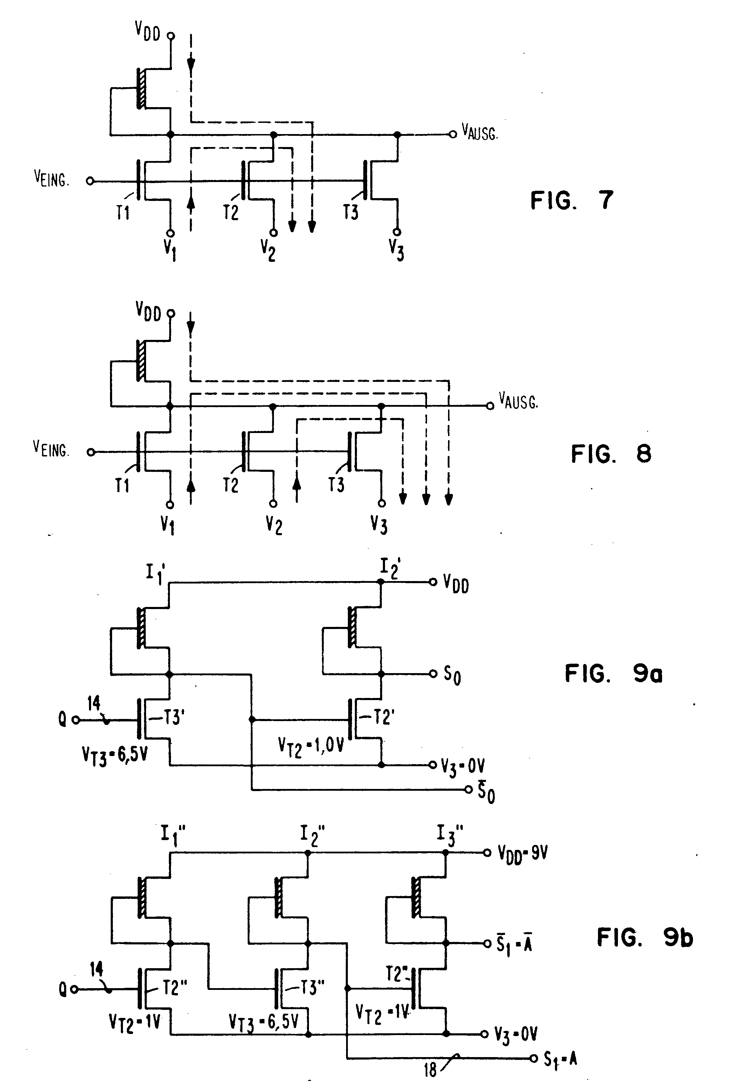

An diesem Punkt fließt der Strom von Lastelement durch T1 an Erde. Ein weiteres Ansteigen von $V_{IN}$ ändert den Wert von $V_{OUT}$ gegenüber V1 so lange nicht wesentlich, wie die Speicherelemente T2 und T3 ausgeschaltet sind, so daß ein zweiter stabiler Zustand »2« eingehalten wird. Wenn einmal $(V_{IN} - V_2) > VT_2$ und $(V_{IN} - V_3) < V_{T3}$ sind, beginnt das Speicherelement T2 einzuschalten. Die Spannung am Ausgangsknotenpunkt $V_{OUT}$ wird jetzt auf $V_2$ heruntergezogen. Da $V_1 > V_2$, ist T1 jetzt in Gegenrichtung vorgespannt und die Rollen von Source und Drain sind vertauscht. Das Lastelement und das Speicherelement T1 wirken dann effektiv als Lastelement für T2. Die Strombahnen für diesen Fall sind in Fig. 7 gezeigt.

Ein weiteres Ansteigen von $V_{IN}$ hält $V_{OUT}$ bei ungefähr $V_2$ oder im Zustand »1« so lange fest, wie:

$$(V_{IN} - V_3) < V_{T3}.$$

Wenn $V_{IN}$ einmal so weit ansteigt, daß $(V_{IN} - V_3)$ den Wert $V_{T3}$ übersteigt, schaltet das Speicherelement T3 ein und zieht $V_{OUT}$ auf $V_3$ oder 0 V herunter. Dann wird $V_2 > V_{OUT}$ und das Speicherelement T2 leitet in Gegenrichtung. Andererseits wirken die Elemente T1 und T2 als Lastelement für T3. Die entsprechenden Strombahnen sind in Fig. 8 gezeigt.

$V_{OUT}$ fällt jetzt auf $V_3$ oder 0 V ab und ergibt den Endzustand »0«. Das Element T1 muß Strom nur vom Lastelement ziehen. Das Element T2 andererseits zieht Strom sowohl vom Lastelement als auch von T1. Das Element T3 zieht Strom von allen drei Elementen. Die Breite für jedes dieser Elemente, der Reihe nach genommen, muß bei der gleichen Länge also folgende Gleichung erfüllen:

$$b1 < b2 < b3.$$

Aus Fig. 6 ist noch zu ersehen, daß die Werte von $V_{T1}$, $V_{T2}$, $V_{T3}$ und $V_1$, $V_2$ und $V_3$ gleich 0 festgelegt werden abhängig von den Prozeßtoleranzen im ungünstigsten Fall, die die gewünschten stabilen Ebenen ergeben.

In einem Prozeß mit vier Masken und Metallgate bei Verwendung von Lastelementen mit Defektelektronen und zusätzlicher Ionenimplantationsmaske erhält man die für die vorgeschlagene Schaltung notwendigen unterschiedlichen Einschaltspannungen leicht durch zusätzliche notwendige Ionenimplantationsmasken. Typ, Energie und Dosierung der Ionenimplantation hängen von Konstruktionsbeschränkungen ab. Bezüglich der Überlagerung ist eine Ionenimplantationsmaske nicht kritisch, da sie normalerweise konservativ ausgelegt ist.

Das Ausgangssignal $V_{OUT}$ auf der Leitung 14 vom Abfrageverstärker 12 wird an den Vierwert/Zweiwert-Umsetzer 16 angelegt, dessen elektrischer Schaltplan im einzelnen in den Fig. 9A bis 9D dargestellt ist. Dieser Umsetzer setzt das vierwertige Eingangssignal auf der Leitung 14 in ein erstes zweiwertiges Ausgangssignal auf der Leitung 18 und ein zweites zweiwertiges Ausgangssignal auf der Leitung 18' um, die denselben numerischen Wert haben wie das vierwertige Eingangssignal auf der Leitung 14.

Wenn in Fig. 5 beispielsweise die logischen Zustände 0, 1, 2 und 3 durch die Spannungspegel $V_3$, $V_2$, $V_1$ und $V_{DD}$ so dargestellt werden, daß $V_3$ Erdpotential und $V_{DD} = 9$ V oder die Speisespannung der Drain der Lastelemente ist, und zur weiteren Demonstration des Konzepts Fig. 5 einen vierwertigen Inverter mit dem Lastelement TL und den aktiven Elementen T1, T2 und T3 darstellt, deren Sources an die Spannungen $V_1 = 6$ V, $V_2 = 3$ V und $V_3 = 0$ V geklemmt sind, dann sind die Schwellwertspannungen dieser Elemente in der angegebenen Reihenfolge $V_{T1} = -4,5$ V, $V_{T2} = 1,0$ V und $V_{T3} = 6,5$ V.

Es sei angenommen, daß das vierwertige Bit Q für den in Fig. 5 gezeigten Inverter umzusetzen ist in zwei äquivalente zweiwertige Bits A und B, deren zweiwertige logische Darstellung von entweder 0 oder 1 den Spannungspegeln $V_3$ bzw. $V_{DD}$ entspricht. Die nachfolgende Wahrheitstabelle enthält alle möglichen logischen Werte von Q und die entsprechenden logischen Werte der zweiwertigen Bits A und B.

Wahrheitstabelle für logische Werte der zweiwertigen Bits A und B

| Q | A | B | $S_0$ | $S_1$ | $S_2$ |
|---|---|---|---|---|---|
| 0 | 0 | 0 | 0 | 0 | 0 |
| 1 | 0 | 1 | 0 | 0 | 1 |
| 2 | 1 | 0 | 0 | 1 | 1 |
| 3 | 1 | 1 | 1 | 1 | 1 |

Drei zweiwertige Variable $S_0$, $S_1$ und $S_2$ werden erzeugt, so daß:

$$A = S_1$$
$$B = S_2 \cdot (\overline{S_0}\overline{S_1} + S_0 S_1)$$

Die logischen Werte dieser Variablen sind in der obigen Wahrheitstabelle angegeben. Zu ihrer Erzeugung werden Eigenschaften von Elementen mit Schwellwertspannungen benutzt, die T1, T2 und T3 in Fig. 5 entsprechen.

Die Variable $S_0 - \overline{S}_0$ muß nur dann einen logischen Wert von 1 haben (oder die Spannung $V_{DD}$), wenn das vierwertige Bit 0 den logischen Wert 3 oder den Spannungspegel $V_{DD}$ hat und durch die in Fig. 9A gezeigte Schaltung erzeugt wird. Da das Element T3' eine Schwellwertspannung von $V_{T3} = 6,5$ V hat, ist es für die logischen Werte 0, 1 oder 2 von Q immer abgeschaltet. Infolgedessen ist für alle diese Q-Werte die Ausgabe $\overline{S}_0$ des Inverters $I_1'$ auf logisch 1 und die Ausgabe $S_0$ des Inverters $I_2'$ auf logisch 0. Wenn Q jedoch den Wert 4 bekommt (oder auf den Spannungspegel $V_{DD}$ geht), schaltet T3' ein, so

daß $\overline{S}_0 = 0$ wird und entsprechend $S_0 = 1$. Somit wird die Variable $\overline{S}_0$ erzeugt.

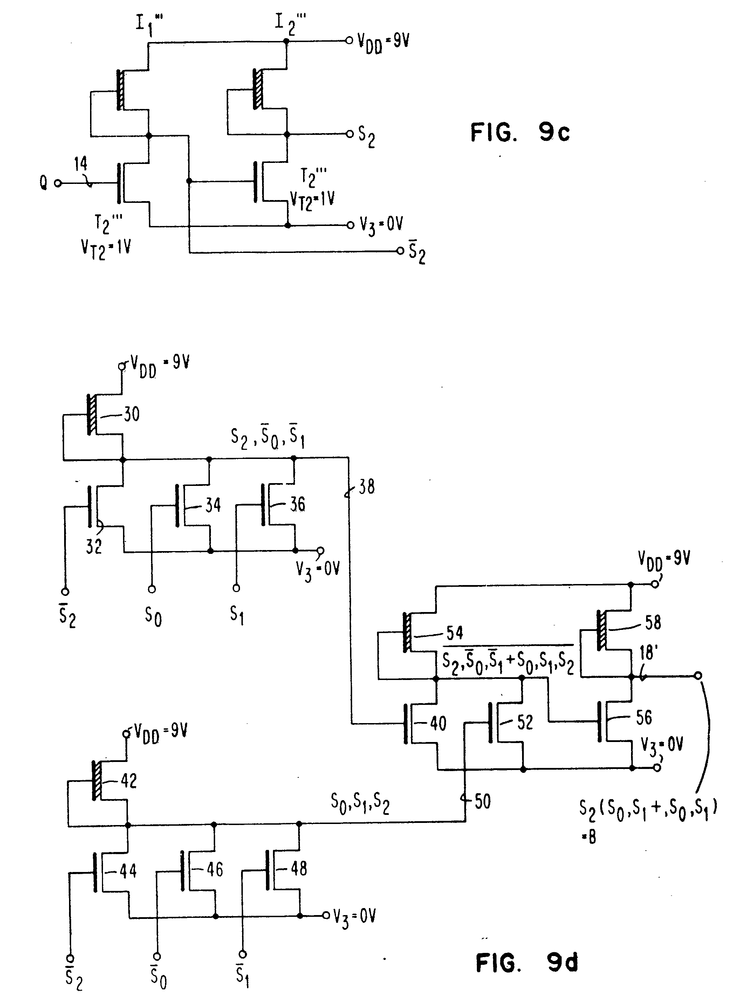

Die Variable $S_1 - \overline{S}_1$ oder A muß den Wert 0 haben, wenn Q entweder 0 oder 1 ist. Das erreicht man mit den Elementen T2'' und T3''. Fig. 9B zeigt die dazu erforderliche Schaltung. Wenn Q gleich 0 oder 1 ist, ist die Eingangsspannung zum Inverter $I_1''$ entweder $V_3 = 0$ V oder $V_2 = 3$ V. Infolgedessen ist das Ausgangssignal von $I_1''$, das Eingangssignal von $I_2''$ ist, gleich $V_{DD}$ bzw. größer als 6,5 V. Dazu wählt man ein geeignetes Aspektverhältnis für den Inverter $I_1''$. Entsprechend liegt $S_1$ des Inverters $I_2''$ auf Erde und 0 für die Werte von Q. Der Inverter $I_3''$ komplementiert einfach die Ausgabe des Inverters $I_2''$ und ergibt so $\overline{S}_1$ oder A auf dem logischen Pegel 1. Wenn jedoch Q den Wert 2 oder 3 hat, reicht die Ausgabe des Inverters $I_1''$ nicht aus, um T3'' einzuschalten, so daß $S_1 = 1$ ist und $\overline{S}_1 = 0$. Auf diese Weise erbringt die in Fig. 9 gezeigte und oben beschriebene Schaltung die Variable $S_1$ oder den Wert von A auf der Leitung 18.

Die Variable $S_2 - \overline{S}_2$ muß für $Q = 0$ auf logisch 0 stehen, für alle anderen Werte von Q jedoch auf logisch 1. Das erreicht man einfach durch die in Fig. 9C gezeigte Schaltung. Da die Einschaltspannung von T2''' oder $V_{T2} = 1$ V ist, ist T2''' des Inverters $I_1'''$ abgeschaltet, wenn $Q = 0$ ist und eingeschaltet, wenn Q den Wert 1, 2 oder 3 hat. Das führt zu der erforderlichen Ausgabe von $I_1'''$, d. h. $\overline{S}_2$ und auch zu derjenigen des Inverters $I_2'''$, die einfach $\overline{S}_2$ komplementiert zu $S_2$.

Da die drei Variablen $S_0$, $S_1$ und $S_2$ jetzt zur Verfügung stehen, ist das erforderliche zweiwertige Bit $A = S_1$, während für das zweiwertige Bit B der Schaltausdruck folgendermaßen lautet:

$$B = S_2 \cdot (\overline{S}_0 \overline{S}_1) + S_0 S_1)$$

Die Schaltungsverwirklichung von B ist allgemein bekannt und nur der Vollständigkeit halber ist in Fig. 9D ein Beispiel gezeigt. Die FET's 32, 34 und 36 sind als NOR-Schaltung mit dem Lastelement 30 geschaltet und ergeben die Ausgabe 38. Die FET's 44, 46 und 48 sind ebenfalls als NOR-Schaltung mit dem Lastelement 42 geschaltet und ergeben das Ausgangssignal 50. Die FET's 40 und 42 mit den Eingängen 38 bzw. 50 sind als NOR-Schaltung mit dem Lastelement 54 geschaltet und erzeugen die von den FET's 56 und 58 invertierte Ausgabe in Form des gewünschten zweiwertigen Bit B bei 18'. Wenn zweiwertige logische Ausgangssignale A und B eine mit einer nachfolgenden FET-Schaltung nicht verträgliche Spannung haben, kann diese mit weiteren Invertern angepaßt werden.

Das resultierende vierwertige Festwert-Speichersystem kann doppelt so viel Information pro Flächeneinheit speichern, wie ein herkömmlicher zweiwertiger Festwertspeicher. Wenn der vierwertige Festwertspeicher 8 außerdem in einem Halbleiterchip enthalten ist, das von den Abfrageverstärkern 12 unabhängig ist, läßt sich außerdem die Anzahl der Ein-/Ausgangs-Stifte auf dem Halbleiterchip heruntersetzen, wodurch auch die Kosten für Packung und Verdrahtung reduziert werden.

## Patentansprüche

1. Festwertspeicher mit matrixförmig angeordneten Feldeffekttransistoren (Q), deren Gate-Elektroden spaltenweise über Wortleitungen (6) ansteuerbar sind, deren Schwellwertspannung ferner entsprechend der zu speichernden Information durch Ionenimplantation im Kanalbereich festlegbar ist und deren Ausgänge zeilenweise zu Ausgangsbitleitungen (10) verbunden sind, dadurch gekennzeichnet, daß N-wertige Schwellwertspannungen (VT 1—4) einstellbar sind, wobei $N > 2$ ist, daß die Abfrageimpulsspannung ($\Phi 2$) auf den Wortleitungen (6) mindestens so groß ist wie die gemeinsame Senkenelektrodenspannung ($V_{DD}$), und daß die Quellenelektroden einer Zeile jeweils zu einer Ausgangsbitleitung (10) verbunden sind, an die ein N-wertiger Abfrageverstärker (12) und ein N-Wert-zu-2-Wert-Konverter (16) angeschlossen sind.

2. Festwertspeicher nach Anspruch 1, dadurch gekennzeichnet, daß die Ausgangsbitleitungen (10) jeweils mit der Senkenelektrode eines Entladeschalttransistors (20) verbunden sind, dessen Quellenelektrode mit Masse verbunden ist und dessen Gateelektrode mit einer Steuerleitung, auf der ein Steuersignal ($\Phi 1$) zur Steuerung des Entladevorgangs anliegt, verbunden ist.

3. Festwertspeicher nach Anspruch 2, dadurch gekennzeichnet, daß dem Entladeschalttransistor (20) die Quelle-Senke-Strecke eines Ausgangstransistors (22) nachgeschaltet ist, dessen Gateelektrode durch ein Steuersignal ($\Phi 2$) gesteuert wird, das auf einer für alle Ausgangstransistoren gemeinsamen Leitung anliegt.

4. Festwertspeicher nach den Ansprüchen 1 bis 3, dadurch gekennzeichnet, daß vierwertige Speicherzellen (Q) dadurch gebildet werden, daß drei Ionenimplantationen ausgeführt werden und der inhärente Schwellwert für einen Kanal ohne Implantation als vierte Schwellwertspannung dient.

## Claims

1. A read-only memory with field-effect transistors (Q) arranged in rows and columns, whose gate electrodes are controlled column-by-column through word lines (6), whose threshold voltage can be determined by ion implantation in the channel region in accordance with the information to be stored, and whose outputs are connected row-by-row to form output bit lines (10), characterized in that N-level threshold voltages (VT 1—4) can be adjusted, where N is greater than 2, that the clock pulse voltage ($\Phi 2$) on the word lines (6) is at least of the same magnitude as the common drain electrode voltage ($V_{DD}$), and that the source electrodes of a row are each connected to form an output bit line (10) to which an N-level sense amplifier (12) and an N-out-of 2-level converter (16) are connected.

2. The read-only memory according to claim 1, characterized in that the output bit lines (10) are each connected to the drain electrode of a discharge load transistor (20) having its source electrode connected to ground and its gate electrode connected to a control line to which a clocking signal ($\Phi1$) for controlling the discharge process is applied.

3. The read-only memory according to claim 2, characterized in that the discharge load transistor (20) is followed by a source-drain path of an output transistor (22) having its gate electrode controlled by a clocking signal ($\Phi2$) which is applied to a line common to all output transistors.

4. The read-only memory according to claims 1 to 3, characterized in that four-state memory cells (Q) are formed by three ion implantations and the inherent threshold level for a channel without implantation acts as a fourth threshold voltage.

## Revendications

1. Mémoire fixe comportant des transistors à effet de champ (Q) arrangés sous forme de matrice, dont les électrodes de porte sont adressables par colonne à travers des lignes de mot (6), dont la tension de seuil peut en outre être déterminée selon l'information à stocker à l'aide d'implantation ionique dans la région de canal, et dont les sorties sont connectées par rangées aux lignes de bit de sortie (10), caractérisée en ce que les tensions de seuil de niveau N (VT 1—4) sont ajustables, N étant dans ce cas plus grand que deux, en ce que la tension d'impulsion de détection ($\Phi2$) appliquée aux lignes de mot (6) est au moins aussi grande que la tension d'électrode de drain commune ($V_{DD}$), et en ce que les électrodes de source d'une rangée sont connectées pour former une ligne de bit de sortie (10) à laquelle est connecté un amplificateur de détection de niveau N (12) et un convertisseur niveau N — niveau 2 (16).

2. Mémoire fixe selon la revendication 1, caractérisée en ce que chaque ligne de bit de sortie (10) est connectée à l'électrode de drain d'un transistor de charge à décharge (20) dont l'électrode de source est connectée à la masse et dont l'électrode de porte est connectée à une ligne de commande à laquelle est appliqué un signal de commande ($\Phi1$) pour commander le processus de décharge.

3. Mémoire fixe selon la revendication 2 caractérisée en ce que le transistor de commande de décharge (20) est suivi par un trajet source-drain d'un transistor de sortie (22) dont l'électrode de porte est commandée par un signal de commande ($\Phi2$), lequel est appliqué à la ligne commune à tous les transistors de sortie.

4. Mémoire fixe selon les revendications 1 à 3, caractérisée en ce que les cellules de mémoire à quatre états (Q) sont formées de telle sorte que trois implantations ioniques ont lieu et que la valeur de seuil inhérente pour un canal sans implantation sert de quatrième tension de seuil.

FIG. 1

FIG. 2

FIG. 3

FIG. 4

$W_1 < W_2 < W_3$

$V_{T1} < V_{T2} < V_{T3}$

FIG. 5

FIG. 6

0 006 167

FIG. 7

FIG. 8

FIG. 9a

FIG. 9b

FIG. 9c

FIG. 9d